# EUROPEAN PATENT APPLICATION

(11) **EP 4 764 552 A1**
(43) Date of publication of application: **24.06.2026**
(21) Application number: 25854523.5
(22) Date of filing: 09.07.2025
(51) Int. Cl.: G01R 31/392, G01R 31/396, G01R 31/367, G01R 31/382, G01R 19/10, G01R 19/165, H02J 7/00

(54) **BATTERY DIAGNOSIS METHOD AND BATTERY TESTING APPARATUS USING SAME**

(30) Priority: 12.08.2024 KR 20240107297
(71) Applicant: LG Energy Solution, Ltd., Seoul 07335 (KR)
(72) Inventor: MUN, Byoung Jun, Daejeon 34122 (KR); SUNG, Chang Hyun, Daejeon 34122 (KR); KANG, Juyoung, Daejeon 34122 (KR); PARK, Hyeonghun, Daejeon 34122 (KR)
(74) Representative: Goddar, Heinz J.
(86) International application number: PCT/KR2025/009936
(87) International publication number: WO 2026/038710

(57) **Abstract**

A battery diagnosis method according to an embodiment of the present invention relates to a method for diagnosing a cell abnormality during charge/discharge testing for a module including a plurality of cells, wherein the battery diagnosis method may comprise the steps of: collecting battery-state-related measurement values for respective cycles of the charge/discharge testing; determining whether a voltage deviation between cells within the module among the battery-state-related measurement values is greater than or equal to a set threshold value; if the voltage deviation between cells within the module is greater than or equal to the set threshold value, calculating data representing the amount of capacity changes in the module relative to the amount of changes in a charging voltage or a discharging voltage; and identifying a trend of the data representing the amount of capacity changes in the module relative to the amount of changes in the charging voltage or the discharging voltage, so as to determine an abnormal cell within the module.

## Description

### [Technical Field]

This application claims priority to and the benefit of Korean Patent Application No.10-2024-0107297 filed in the Korean Intellectual Property Office on August 12, 2024 the entire contents of which are incorporated herein by reference.

The present invention relates to a method for diagnosing batteries and an battery test apparatus using the same, and more particularly, to a method for diagnosing an abnormal cell included in a battery module under performance test and a battery test apparatus using the same.

### [Background Art]

Secondary batteries, capable of recharging and reuse, are manufactured as battery modules or packs by connecting multiple battery cells in series based on the output capacity required by a corresponding device, serving as power sources for diverse applications. Recently, with the development of portable electronic devices, electric vehicles, and large-capacity power storage systems, a need for large-capacity batteries is increasing.

Secondary batteries may be applied to systems in the form of assemblies, such as battery modules, in which multiple battery cells are connected in series and parallel, or battery packs, in which battery modules are connected in series and parallel, depending on the system requirements. For medium- to large-sized devices such as electric vehicles, high-capacity battery systems, in which multiple battery packs are connected in parallel, may be applied to meet the device's capacity requirements.

Meanwhile, secondary batteries may undergo performance evaluation through a charge-discharge testing at the final stage of the manufacturing process before shipment. The charge-discharge testing involves connecting each charge-discharge circuit to the cell or module being tested, and repeating the charge, discharge, and rest steps multiple times. During charge-discharge testing, voltage measurements for each cell (or bank) may be monitored to diagnose cells exhibiting abnormalities.

In particular, methods for identifying voltage measurement abnormalities are typically used by comparing instantaneous voltage deviations between cells or directly visualizing voltage data for visual inspection, which is inefficient.

### [Detailed Description of the Invention]

### [Technical Problem]

To obviate one or more problems of the related art, embodiments of the present disclosure provide a battery test apparatus capable of diagnosing cells exhibiting abnormal behavior within a battery module undergoing performance testing.

To obviate one or more problems of the related art, embodiments of the present disclosure also provide a battery diagnostic method performed by the battery test apparatus.

### [Technical Solution]

In order to achieve the objective of the present disclosure, a battery test apparatus, for performing a charge/discharge test on a module including a plurality of battery cells, may include at least one processor; and a memory configured to store at least one instruction executed by the at least one processor.

Here, the at least one instruction executed through the processor may include an instruction to collect battery state-related measurements for each cycle of the charge/discharge test; an instruction to determine whether a voltage deviation between cells within the module, among the battery state-related measurements, is greater than or equal to a determined threshold; an instruction to generate data indicating a rate of change in module capacity with respect to charge voltage or discharge voltage, if the voltage deviation between cells within the battery module is greater than or equal to the determined threshold; and an instruction to determine an abnormal cell within the module by identifying a trend in the data indicating the rate of change in module capacity with respect to charge voltage or discharge voltage.

Here, the data indicating the rate of change in module capacity with respect to charge voltage or discharge voltage may include data on a derivative graph indicating a differential module capacity with respect to charge voltage during a charge period included in one cycle.

Furthermore, the data indicating the rate of change in module capacity with respect to charge voltage or discharge voltage may include data on a derivative graph indicating a differential module capacity with respect to discharge voltage during a discharge period included in one cycle.

The instruction to determine an abnormal cell within the module may include an instruction to generate a derivative graph indicating a differential module capacity with respect to a charge/discharge voltage for each cell; an instruction to compare data for each cell based on one or more of the positions of peaks on the graph, the number of peaks, and the magnitudes of peaks; and an instruction to select a cell that exhibits a different trend from other cells in terms of the positions of the peaks, the number of peaks, or the magnitude of the peaks; and an instruction to determine a bank exhibiting the different trend as an abnormal bank.

Here, the module may include a plurality of banks connected in series, each bank including a plurality of bank cells connected in parallel. Thus, determining an abnormal cell within the module may mean identifying a bank containing the abnormal cell.

Meanwhile, the instruction to determine whether the voltage deviation between cells within the module, among the battery state-related measurements, is greater than or equal to the determined threshold value may include an instruction to generate a charge profile or a discharge profile based on the battery state-related measurements for each cycle; an instruction to compare the voltage between cells for each comparison section included in the charge profile or the discharge profile; and an instruction to compare the voltage deviation among cells for each comparison section with a predetermined threshold.

Furthermore, the at least one instruction may further include an instruction to exclude a corresponding module from diagnosis, when the voltage deviation between cells in each comparison section is less than the determined threshold, as a result of determining whether the voltage deviation between cells within the module is greater than or equal to the determined threshold.

According to another embodiment of the present disclosure, a method of diagnosing cell abnormality in a charge/discharge test on a module including a plurality of battery cells, may include collecting battery state-related measurements for each cycle of the charge/discharge test; determining whether a voltage deviation between cells within the module, among the battery state-related measurements, is greater than or equal to a determined threshold; generating data indicating a rate of change in module capacity with respect to charge voltage or discharge voltage, if the voltage deviation between cells within the battery module is greater than or equal to the determined threshold; and determining an abnormal cell within the module by identifying a trend in the data indicating the rate of change in module capacity with respect to charge voltage or discharge voltage.

Here, the data indicating the rate of change in module capacity with respect to charge voltage or discharge voltage may include data on a derivative graph indicating a differential module capacity with respect to charge voltage during a charge period included in one cycle.

Furthermore, the data indicating the rate of change in module capacity with respect to charge voltage or discharge voltage may include data on a derivative graph indicating a differential module capacity with respect to discharge voltage during a discharge period included in one cycle.

The determining of an abnormal cell within the module may include generating a derivative graph indicating a differential module capacity with respect to a charge/discharge voltage for each cell; comparing data for each cell based on one or more of the positions of peaks on the graph, the number of peaks, and the magnitudes of peaks; selecting a cell that exhibits a different trend from other cells in terms of the positions of the peaks, the number of peaks, or the magnitude of the peaks; and determining a bank exhibiting the different trend as an abnormal bank.

The module includes a plurality of banks connected in series, each bank including a plurality of bank cells connected in parallel. Thus, determining an abnormal cell within the module may mean identifying a bank containing the abnormal cell.

The determining of whether the voltage deviation between cells within the module, among the battery state-related measurements, is greater than or equal to the determined threshold value may include generating a charge profile or a discharge profile based on the battery state-related measurements for each cycle; comparing the voltage between cells for each comparison section included in the charge profile or the discharge profile; and comparing the voltage deviation among cells for each comparison section with a predetermined threshold.

The method may further include excluding a corresponding module from diagnosis, when the voltage deviation between cells in each comparison section is less than the determined threshold, as a result of determining whether the voltage deviation between cells within the module is greater than or equal to the determined threshold.

### [Advantageous Effects]

According to embodiments of the present disclosure, it is possible to efficiently identify a bank in which an abnormality occurs in a module charge/discharge test.

### [Brief Description of the Drawings]

FIG. 1 illustrates a structure of a battery module to which the present invention can be applied.
FIG. 2 is a graph illustrating charge curves and discharge curves derived from a battery charge/discharge test.
FIG. 3 is a conceptual diagram illustrating an exemplary battery charge/discharge cycle.
FIG. 4 is an operational flowchart of a battery diagnosis method according to embodiments of the present invention.
FIG. 5a is a graph showing a charge voltage profile of a normal module and FIG. 5b is a graph showing a charge voltage profile of an abnormal module.
FIG. 6a shows a derivative graph of the differential capacity with respect to charge voltage for a normal module and FIG. 6b shows a derivative graph of the differential capacity with respect to charge voltage for a module containing an abnormal cell.
FIG. 7 is a block diagram of a testing system including a battery test apparatus according to embodiments of the present invention and a battery module.
FIG. 8 is a block diagram of a battery test apparatus according to embodiments of the present invention.

100: battery module
200: charger/discharger
300: measuring device
500: battery test apparatus

### [Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Some terms used herein are defined as follows.

A battery cell is a basic unit that serves to store power and a battery module refers to an assembly in which a plurality of battery cells is electrically connected.

Battery's capacity is the amount of electricity a charged battery can produce when discharged until it reaches the nominal voltage, typically expressed in ampere-hours (Ah). Furthermore, the nominal capacity of a battery is the capacity that must be satisfied under specified conditions and refers to a set capacity [Ah] of the battery determined by the battery manufacturer during development.

State of Charge (SOC) refers to a current state of charge of a battery, represented in percent points [%]. In addition, State of Health (SOH) indicates the degree of aging of a battery and is defined as the percentage of the maximum amount of dischargeable power of a fully charged battery at a given point in time relative to its initial capacity.

Charge rate (C-rate) indicates the speed at which a battery is charged or discharged. It is also called the charge/discharge rate. The unit for charge rate is C (Capacity). The C-rate is calculated by dividing the charge/discharge current (A) by the battery's nominal capacity (Ah), with the standard value being 1C.

Hereinafter, exemplary embodiments of the present invention will be described in detail with reference to the accompanying drawings.

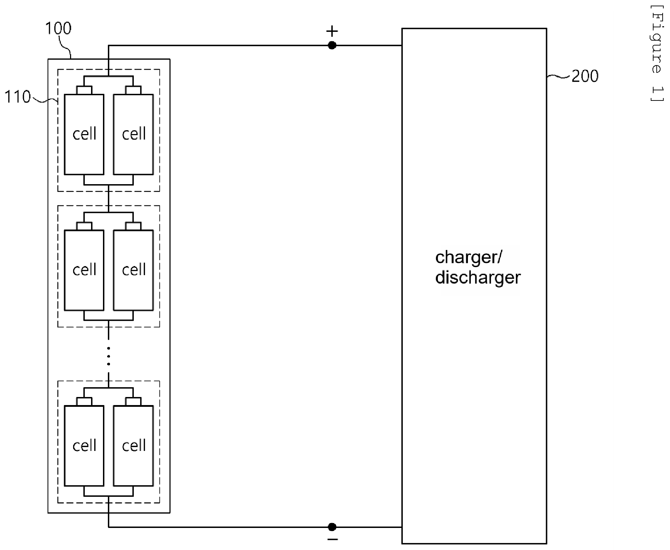

FIG. 1 illustrates a structure of a battery module to which the present invention can be applied.

The battery module 100 illustrated in FIG. 1 is an exemplary battery module in which abnormalities can be diagnosed using a battery test apparatus according to embodiments of the present invention. Referring to FIG. 1, the battery module may be configured with multiple battery cells connected in series and parallel.

More specifically, in the example of FIG. 1, two battery cells are connected in parallel to form a single battery bank 110. In this disclosure, a "battery bank" may refer to a set of battery cells connected in parallel. A single module may be configured with multiple battery banks connected in series. In the module structure illustrated in FIG. 1, the voltage of each cell is equal to the voltage of the bank to which the cell belongs. Furthermore, the current flowing through each bank is equal, and the module capacity (Ah) is determined by the current flowing through the module, i.e., the current flowing through the bank.

Meanwhile, the present invention is not limited by the number of battery banks 110 or battery cells. The number of battery cells included in each battery bank 110 and the number of battery banks included in a battery module 100 may vary depending on the required charge/discharge capacity or output voltage of the battery module 100. Furthermore, each battery cell may include a rechargeable lithium-ion battery, a lithium polymer battery, a nickel-cadmium (Ni-Cd) battery, a nickel-metal hydride (Ni-MH) battery, a nickel-zinc (Ni-Zn) battery, or the like.

Batteries are typically manufactured through electrode processes, assembly processes, and activation/inspection processes. The completed battery, through these processes, is shipped in the form of a battery pack (or battery module) comprising a plurality of battery cells connected in series. The battery pack is connected to a load through the positive and negative terminals and can perform charge/discharge operations. The battery packs may be connected in series or parallel depending on the requirements of the system in which the battery is used.

During the battery inspection process, a charge/discharge testing may be conducted to evaluate battery performance. The charge/discharge testing is performed by repeating cycles of charging and/or discharging the target battery module several times. The charge and discharge testing may be performed by connecting a charger/discharger 200 to the positive and negative terminals of the module. The charger/discharger performing charge and discharge tests may have various structures depending on specifications or options and typically have multiple charge/discharge channels.

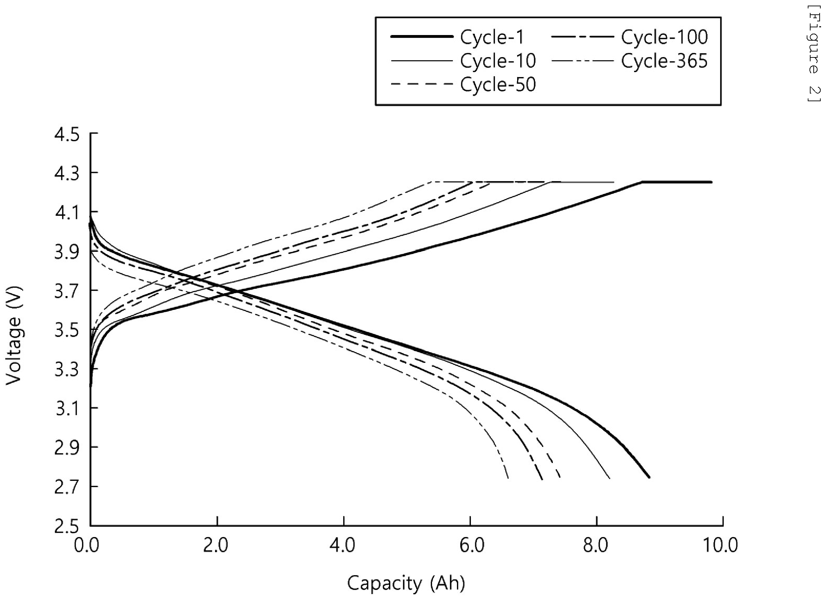

FIG. 2 is a graph illustrating charge and discharge curves derived from a battery charge/discharge testing.

Referring to FIG. 2, the charge/discharge testing is typically conducted by applying a constant current to the battery cell under test and involve a large number of cycles. In the graph of FIG. 2, the x-axis represents capacity (Ah), and the y-axis represents voltage (V). During the discharge period using a negative current, the battery cell voltage tends to decrease over time. During the charge period using a positive current, the voltage tends to increase as the time of applying current increases. Furthermore, it can be understood that, as the cycle progresses, battery capacity decreases due to degradation and the charge/discharge curve changes.

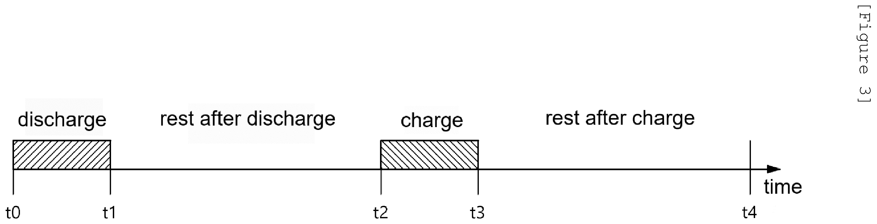

FIG. 3 is a conceptual diagram illustrating an exemplary battery charge/discharge cycle.

A single charge/discharge cycle may include a discharge phase, a rest phase, a charge phase, and a rest phase. As illustrated in the example shown in FIG. 3, a single charge/discharge cycle typically includes one or more "discharge" phases and one or more "charge" phases, with a rest phases following each "discharge" and "charge" phases. A charge voltage profile may be acquired during the charge phase within a cycle, and a discharge voltage profile may be acquired during the discharge phase.

Meanwhile, in a process charging/discharging the battery, the battery voltage may stabilize during a period of rest phase after charging or discharging. During periods of charge phase and discharge phase, each channel of the charge/discharge test apparatus and the target module are electrically connected. During a period of rest phase, the charge/discharge test apparatus and the battery may not be electrically connected. For example, the charge/discharge test apparatus may control an internal switching module to block power transmission through the charge/discharge terminals during a period of rest phase.

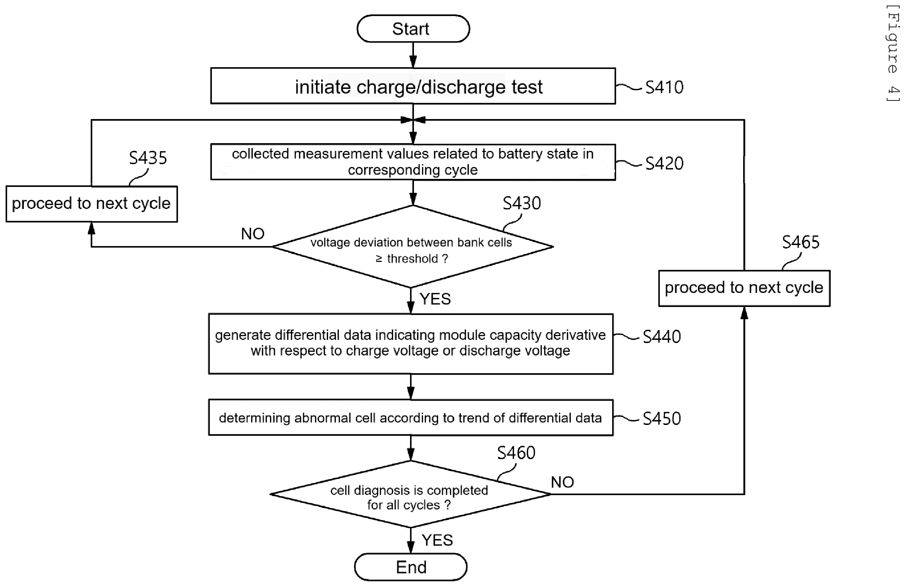

FIG. 4 is an operational flowchart of a battery diagnosis method according to embodiments of the present invention.

Battery diagnosis according to embodiments of the present invention may be performed during a charge/discharge testing for performance evaluation. Therefore, the battery diagnosis method according to embodiments of the present invention may be performed by a battery test apparatus according to embodiments of the present invention.

When a charge/discharge test for performance testing of a target battery (e.g., a battery module) is initiated (S410), measurement values related to the battery's state during a charge or discharge period within each charge/discharge cycle are collected (S420). Here, the test apparatus may receive relevant measurements from various sensors connected to the battery module, such as current sensors and voltage sensors.

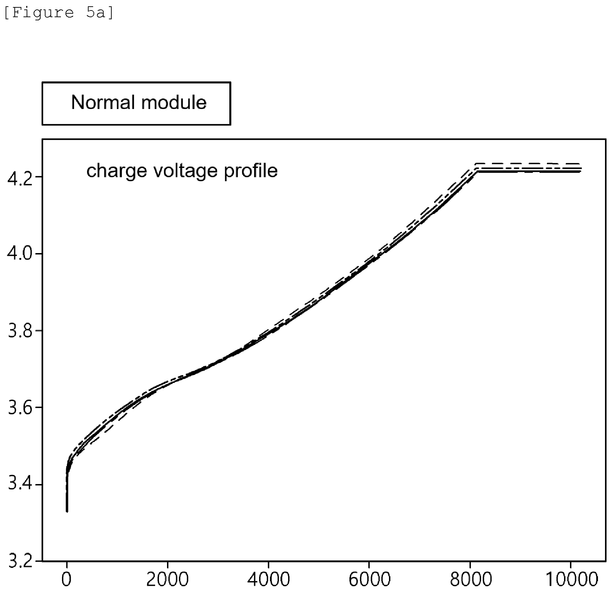

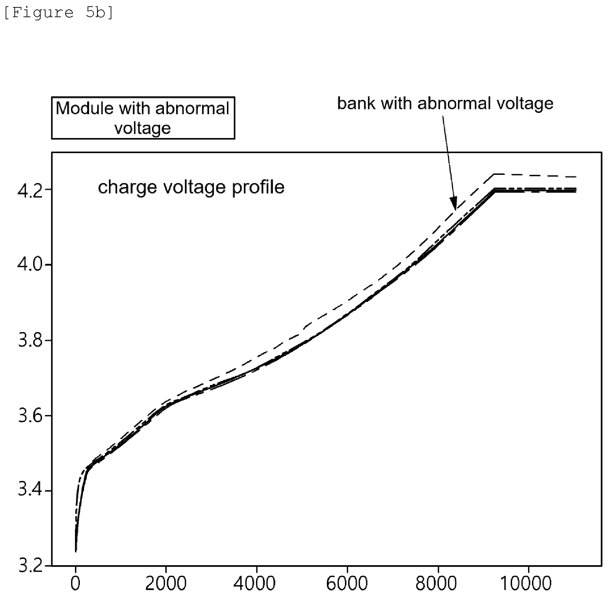

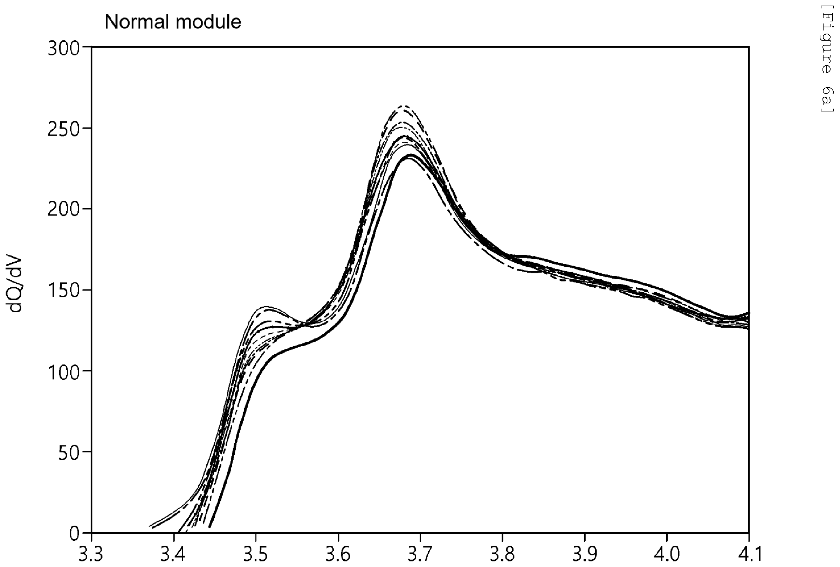

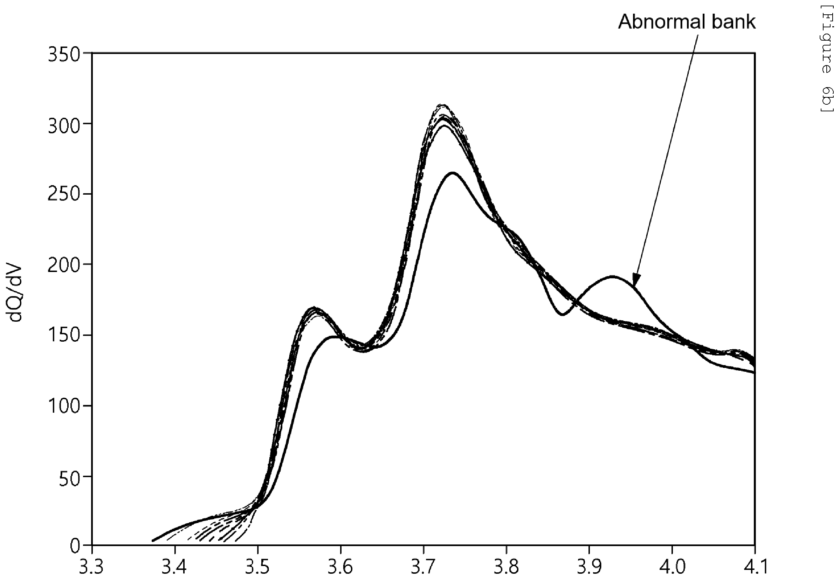

Here, the measured values may include the voltage of each cell measured during the charge or discharge period of each test cycle and the current applied to the module. In other words, the voltage of each cell, the current applied to the module, and the module's capacity, which vary over time within the cycle, may be measured or calculated. Using voltage data acquired during the charge/discharge cycle, a charge voltage profile or discharge voltage profile, as illustrated in FIGS. 5A and 5B, which will be discussed later, may be generated. Furthermore, using voltage and current data acquired during the charge/discharge cycle, a derivative graph of voltage-to-capacity change, as illustrated in FIGS. 6A and 6B, which will be discussed later, may be generated.

Afterwards, the battery test apparatus may determine whether a voltage deviation among cells within the module, among the collected battery state-related measurements, is equal to or greater than a determined threshold value (S430). In the battery structure according to embodiments of the present invention, as illustrated in FIG. 1, multiple cells are connected in parallel within a single bank, so the voltage of each cell is identical to the voltage of the bank in which the cell is located. Therefore, in this disclosure, the "cell voltage" is used synonymously with the bank voltage or the voltage of the bank cell.

The step of determining whether the inter-cell voltage deviation is equal to or greater than the determined threshold value (S430) may include the steps of: generating a charge profile or a discharge profile based on the battery state-related measurements for each cycle; comparing the voltage between cells for each comparison section included in the charge profile or the discharge profile; and comparing the voltage deviation among cells for each comparison section with a predetermined threshold. Here, the charge profile may take the form illustrated in FIGS. 5A and 5B. Furthermore, the comparison intervals may be configured by dividing the charge or discharge profile into multiple sections and the inter-cell voltage deviation may be compared in detail for each comparison interval.

If the inter-cell voltage deviation within the battery module is determined to be below the threshold in each comparison interval as a result of determination whether the inter-cell voltage deviation in the battery module is equal to or greater than the threshold, the module is excluded from further diagnosis. In other words, the module is determined to be normal and proceeds to the next cycle (S435). Determining whether the inter-cell voltage deviation is equal to or greater than the determined threshold is intended to exclude capacity reduction due to normal degradation from abnormal diagnosis. In other words, if normal degradation occurs, the voltage deviation between cells within a module is not significant, so the module is determined not to contain any abnormal cell and no further diagnosis (S440, S450) is performed. Here, an abnormal cell may refer to a cell whose voltage behavior differs from that of a normal cell due to a defect such as a tab-torn.

Meanwhile, if the voltage deviation among cells within a battery module is equal to or greater than the determined threshold (e.g., S430), differential data indicating a rate of change in module capacity with respect to charge voltage or discharge voltage may be generated (S440). According to one embodiment of the present invention, the data indicating the rate of change in module capacity with respect to charge voltage or discharge voltage may include data on a derivative graph indicating a differential module capacity with respect to charge voltage during a charge period included in one cycle. According to another embodiment of the present invention, the data indicating the rate of change in module capacity with respect to charge voltage or discharge voltage may include data on a derivative graph indicating a differential module capacity with respect to discharge voltage during a discharge period included in one cycle.

Here, the derivative graph indicating the differential module capacity with respect to charge voltage during a charge period included in one cycle may take the form of a graph as illustrated in FIGS. 6A and 6B.

Thereafter, the battery test apparatus may determine a trend of data representing the data indicating the rate of change in module capacity with respect to charge voltage or discharge voltage, thereby determining an abnormal cell within the module (S450). Here, the step of determining an abnormal cell within the module may include: generate a derivative graph indicating a differential module capacity with respect to a charge/discharge voltage for each cell; comparing data for each cell based on one or more of the positions of peaks on the graph, the number of peaks, and the magnitudes of peaks; selecting a cell that exhibits a different trend from other cells in terms of the positions of the peaks, the number of peaks, or the magnitude of the peaks; and determining a bank exhibiting the different trend as an abnormal bank.

When cell diagnosis is completed for data collected in one cycle, it is determined whether cell diagnosis is completed for all cycles included in the charge/discharge test (S460), and if there are cycles remaining, proceed to the next cycle (S465) is proceeded and the above-described procedures (S420 to S450) may be repeated.

FIG. 5a is a graph showing a charge voltage profile of a normal module and FIG. 5b is a graph showing a charge voltage profile of an abnormal module.

FIGS. 5a and 5b are charge voltage profiles derived by a battery test apparatus according to embodiments of the present invention. In FIGS. 5a and 5b, the x-axis represents time, the y-axis represents voltage, and the hourly voltage data for multiple cells for one charge/discharge cycle are superimposed.

The profile in FIG. 5a superimposes the charge profiles of multiple cells within a normal module, confirming that the voltage deviation among cells in the normal module is not significant. In contrast, FIG. 5b superimposes the charge profiles of multiple cells containing an abnormal cell, confirming that the corresponding bank curve with the abnormal voltage is located away from the curves for other cells. In other words, the voltage of the abnormal cell deviates by more than or equal to a threshold compared to the voltages of other normal cells.

Meanwhile, although not shown, according to another embodiment of the present invention, discharge profiles can be obtained using data acquired during the discharge period. Even in the case of discharge profiles, the discharge voltage of an abnormal cell shows a deviation greater than a threshold compared to the discharge voltages of other normal cells.

FIG. 6a shows a derivative graph of the differential capacity with respect to charge voltage for a normal module and FIG. 6b shows a derivative graph of the differential capacity with respect to charge voltage for a module containing an abnormal cell.

FIGS. 6a and 6b are graphs illustrating the form of derivative data of a rate of change in capacity versus charge voltage produced by a battery test apparatus according to embodiments of the present invention. In FIGS. 6a and 6b, the x-axis represents the voltage (V) of the battery cell, and the y-axis represents derivative data (dQ/dV) (Ah/V) of the differential capacity with respect to voltage of a cell.

As previously described with reference to FIG. 4, the battery test apparatus according to embodiments of the present invention may determine whether a battery cell is abnormal by analyzing the form of a derivative graph of the differential module capacity with respect to charge voltage of a cell (bank or bank cell) or a derivative graph of the differential module capacity with respect to discharge voltage of a cell (bank or bank cell).

More specifically, the battery test apparatus according to embodiments of the present invention may compare data for each cell based on one or more of the peak positions, number of peaks, and peak sizes on the derivative graph. By selecting one or more cells that exhibit trends different from those of other cells in terms of peak positions, number of peaks, or peak sizes, the battery test apparatus may determine that a corresponding bank exhibiting such trend as an abnormal bank.

For example, from FIG. 6b, it can be understood that a bank containing an abnormal cell has one more peaks than the other banks, and furthermore, a peak located at the same position as other banks has a significantly different size compared to the curves of other banks.

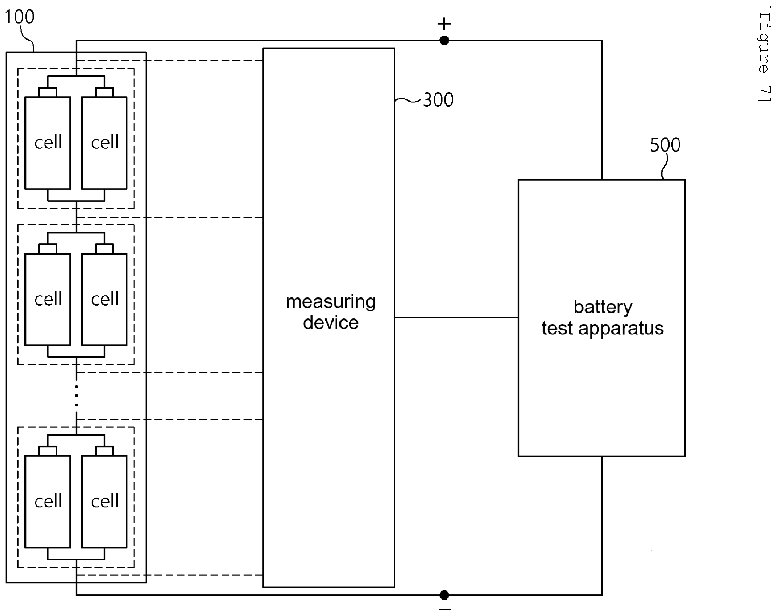

FIG. 7 is a block diagram of a testing system including a battery test apparatus according to embodiments of the present invention and a battery module.

The battery test apparatus 500 according to embodiments of the present invention may be implemented by including a charger/discharger (e.g., a charger/discharger 200 as illustrated in FIG. 1) that repeatedly performs multiple charge/discharge cycles on a battery module 100 according to a charging/discharging pattern. The battery test apparatus 500 may also be configured as hardware separate from the charger/discharger. In this case, the battery test apparatus 500 may control the charger/discharger to charge/discharge the battery module according to the charging/discharging pattern.

The battery test apparatus 500 may also be connected to a measuring device 300 that includes various sensors (such as a temperature sensor, a voltage sensor, and a current sensor) to receive battery state-related measurement data. The battery state-related measurement data may include the voltage of each cell measured during the charge or discharge period of each test cycle and the current applied to the module.

The battery test apparatus 500 may collect battery state-related measurements for each cycle of the charge/discharge test, and determine whether the voltage deviation between cells within the module, among the battery state-related measurements, is greater than or equal to a determined threshold. If the voltage deviation between cells within the battery module is greater than or equal to the determined threshold, the battery test apparatus 500 may generate data representing a rate of change in module capacity with respect to charge voltage or discharge voltage, and determine a trend of the data representing a rate of change in module capacity with respect to charge voltage or discharge voltage, thereby determining an abnormal cell within the module.

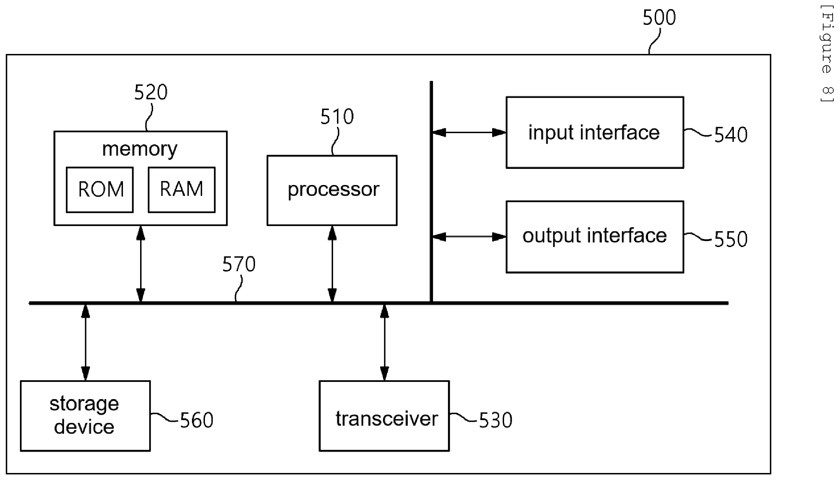

FIG. 8 is a block diagram of a battery test apparatus according to embodiments of the present invention.

Referring to FIG. 8, the battery test apparatus 500 according to embodiments of the present invention may include a processor 510 and a memory 520 that stores at least one instruction executed through the processor. Here, the processor may be, for example, a Micro Controller Unit (MCU) or another form of controller.

Here, the at least one instruction executed through the processor may include an instruction to collect battery state-related measurements for each cycle of the charge/discharge test; an instruction to determine whether a voltage deviation between cells within the module, among the battery state-related measurements, is greater than or equal to a determined threshold; an instruction to generate data indicating a rate of change in module capacity with respect to charge voltage or discharge voltage, if the voltage deviation between cells within the battery module is greater than or equal to the determined threshold; and an instruction to determine an abnormal cell within the module by identifying a trend in the data indicating the rate of change in module capacity with respect to charge voltage or discharge voltage.

Here, the data indicating the rate of change in module capacity with respect to charge voltage or discharge voltage may include data on a derivative graph indicating a differential module capacity with respect to charge voltage during a charge period included in one cycle.

Furthermore, the data indicating the rate of change in module capacity with respect to charge voltage or discharge voltage may include data on a derivative graph indicating a differential module capacity with respect to discharge voltage during a discharge period included in one cycle.

The instruction to determine an abnormal cell within the module may include an instruction to generate a derivative graph indicating a differential module capacity with respect to a charge/discharge voltage for each cell; an instruction to compare data for each cell based on one or more of the positions of peaks on the graph, the number of peaks, and the magnitudes of peaks; and an instruction to select a cell that exhibits a different trend from other cells in terms of the positions of the peaks, the number of peaks, or the magnitude of the peaks; and an instruction to determine a bank exhibiting the different trend as an abnormal bank.

Here, the module may include a plurality of banks connected in series, each bank including a plurality of bank cells connected in parallel. Thus, determining an abnormal cell within the module may mean identifying a bank containing the abnormal cell.

Meanwhile, the instruction to determine whether the voltage deviation between cells within the module, among the battery state-related measurements, is greater than or equal to the determined threshold value may include an instruction to generate a charge profile or a discharge profile based on the battery state-related measurements for each cycle; an instruction to compare the voltage between cells for each comparison section included in the charge profile or the discharge profile; and an instruction to compare the voltage deviation among cells for each comparison section with a predetermined threshold.

Furthermore, the at least one instruction may further include an instruction to exclude a corresponding module from diagnosis, when the voltage deviation between cells in each comparison section is less than the determined threshold, as a result of determining whether the voltage deviation between cells within the module is greater than or equal to the determined threshold.

Meanwhile, the battery test apparatus 500 according to embodiments of the present invention may further include a transceiver 530, an input interface 540, an output interface 550, a storage device 560, etc. Respective components included in the battery test apparatus 500 may be connected by a bus 570 and can communicate with each other.

In addition, the memory 520 (or storage) may include at least one of a volatile storage medium and a non-volatile storage medium. For example, the memory may include at least one of read only memory (ROM) and random access memory (RAM), and may include electrically erasable programmable read-only Memory (EEPROM).

According to the above-described embodiments of the present invention, it is possible to efficiently identify a bank in which an abnormality occurs in a module charge/discharge test.

The operations of the method according to the embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range without departing from the spirit and the area of the present invention described in the appending claims.

## Claims

1. A battery test apparatus for performing a charge/discharge test on a module including a plurality of battery cells, the apparatus comprising:
at least one processor; and
a memory configured to store at least one instruction executed by the at least one processor,
wherein the at least one instruction includes:
an instruction to collect battery state-related measurements for each cycle of the charge/discharge test;
an instruction to determine whether a voltage deviation between cells within the module, among the battery state-related measurements, is greater than or equal to a determined threshold;
an instruction to generate data indicating a rate of change in a module capacity with respect to a charge voltage or a discharge voltage, if the voltage deviation between cells within the module is greater than or equal to the determined threshold; and
an instruction to determine an abnormal cell within the module by identifying a trend in the data indicating the rate of change in the module capacity with respect to the charge voltage or the discharge voltage.

2. The apparatus of claim 1, wherein the data indicating the rate of change in the module capacity with respect to the charge voltage or the discharge voltage includes
data on a derivative graph indicating a differential module capacity with respect to a charge voltage during a charge period included in one cycle.

3. The apparatus of claim 1, wherein the data indicating the rate of change in the module capacity with respect to the charge voltage or the discharge voltage further includes
data on a derivative graph indicating a differential module capacity with respect to a discharge voltage during a discharge period included in one cycle.

4. The apparatus of claim 1, wherein the instruction to determine an abnormal cell within the module includes
an instruction to generate a derivative graph indicating a differential module capacity with respect to a charge/discharge voltage for each cell;
an instruction to compare data for each cell based on one or more of positions of peaks on the derivative graph, the number of peaks, and the magnitudes of peaks; and
an instruction to select a cell that exhibits a different trend from other cells in terms of the positions of the peaks, the number of peaks, or the magnitude of the peaks; and
an instruction to determine a bank exhibiting the different trend as an abnormal bank.

5. The apparatus of claim 4, wherein the module includes a plurality of banks connected in series, wherein each bank includes a plurality of bank cells connected in parallel, and
wherein the instruction to determine an abnormal cell within the module includes an instruction to identify a bank containing the abnormal cell.

6. The apparatus of claim 1, wherein the instruction to determine whether the voltage deviation between cells within the module, among the battery state-related measurements, is greater than or equal to the determined threshold value includes:
an instruction to generate a charge profile or a discharge profile based on the battery state-related measurements for each cycle;
an instruction to compare the voltage between cells for each comparison section included in the charge profile or the discharge profile; and
an instruction to compare the voltage deviation among cells for each comparison section with a predetermined threshold.

7. The apparatus of claim 1, wherein the at least one instruction further includes:
an instruction to exclude a corresponding module from a diagnosis, when the voltage deviation between cells in each comparison section is less than the determined threshold, as a result of determining whether the voltage deviation between cells within the module is greater than or equal to the determined threshold.

8. A method of diagnosing cell abnormality in a charge/discharge test on a module including a plurality of battery cells, the method comprising:
collecting battery state-related measurements for each cycle of the charge/discharge test;
determining whether a voltage deviation between cells within the module, among the battery state-related measurements, is greater than or equal to a determined threshold;
generating data indicating a rate of change in a module capacity with respect to a charge voltage or a discharge voltage, if the voltage deviation between cells within the module is greater than or equal to the determined threshold; and
determining an abnormal cell within the module by identifying a trend in the data indicating the rate of change in the module capacity with respect to the charge voltage or the discharge voltage.

9. The method of claim 8, wherein the data indicating the rate of change in the module capacity with respect to the charge voltage or the discharge voltage includes
data on a derivative graph indicating a differential module capacity with respect to a charge voltage during a charge period included in one cycle.

10. The method of claim 8, wherein the data indicating the rate of change in the module capacity with respect to the charge voltage or the discharge voltage further includes
data on a derivative graph indicating a differential module capacity with respect to a discharge voltage during a discharge period included in one cycle.

11. The method of claim 9, wherein the determining of an abnormal cell within the module includes
generating a derivative graph indicating a differential module capacity with respect to a charge/discharge voltage for each cell;
comparing data for each cell based on one or more of positions of peaks on the derivative graph, the number of peaks, and the magnitudes of peaks;
selecting a cell that exhibits a different trend from other cells in terms of the positions of the peaks, the number of peaks, or the magnitude of the peaks; and
determining a bank exhibiting the different trend as an abnormal bank.

12. The method of claim 11, wherein the module includes a plurality of banks connected in series, wherein each bank includes a plurality of bank cells connected in parallel, and
wherein the determining of an abnormal cell within the module includes identifying a bank containing the abnormal cell.

13. The method of claim 8, wherein the determining of whether the voltage deviation between cells within the module, among the battery state-related measurements, is greater than or equal to the determined threshold value includes
generating a charge profile or a discharge profile based on the battery state-related measurements for each cycle;
comparing the voltage between cells for each comparison section included in the charge profile or the discharge profile; and
comparing the voltage deviation among cells for each comparison section with a predetermined threshold.

14. The method of claim 11, further comprising:
excluding a corresponding module from a diagnosis, when the voltage deviation between cells in each comparison section is less than the determined threshold, as a result of determining whether the voltage deviation between cells within the module is greater than or equal to the determined threshold.
